# EUROPÄISCHE PATENTSCHRIFT

(11) **EP 2 921 453 B1**
(45) Veröffentlichungstag und Bekanntmachung des Hinweises auf die Patenterteilung: **05.10.2016**
(21) Anmeldenummer: 15155700.6
(22) Anmeldetag: 19.02.2015
(51) Int. Cl.: B81B 3/00

(54) **Mikromechanische Sensoranordnung und entsprechendes Herstellungsverfahren**
Micro-mechanical sensor assembly and corresponding production method
Agencement de capteur micro-mécanique et procédé de fabrication correspondant

(30) Priorität: 20.03.2014 DE 102014205178; 21.03.2014 DE 102014205326
(43) Veröffentlichungstag der Anmeldung: 23.09.2015
(73) Patentinhaber: ROBERT BOSCH GMBH, 70442 Stuttgart (DE)
(72) Erfinder: Hernandez Guillen, Francisco, 70178 Stuttgart (DE); Heuck, Friedjof, 70197 Stuttgart (DE)

(56) Entgegenhaltungen:
- US-A1- 2009 261 430
- US-A1- 2012 210 792
- US-A1- 2014 024 161

## Beschreibung

Die vorliegende Erfindung betrifft eine mikromechanische Sensoranordnung und ein entsprechendes Herstellungsverfahren.

Die US 2014/00224161 A1 offenbart eine mikromechanische Sensoranordnung mit einer Substratschicht, einer über der Substratschicht, einer über der ersten Isolationsschicht angeordneten ersten einkristallinen Funktionsschicht, in der ein Feder-Masse-System ausgebildet ist, einer über der ersten einkristallinen Funktionsschicht angeordneten zweiten einkristallinen Funktionsschicht wobei in der zweiten einkristallinen Funktionsschicht ein piezoresistiver Sensorwiederstandsbalken ausgebildet ist.

Die US 2009/0261430 A1 offenbart eine mirkomechanische Sensorvorrichtung mit einem Feder-Masse-System, bei dem eine physikalische Größe über eine Kapazitätsänderung zwischen Elektroden erfassbar ist, welche durch die Auslenkung des Feder-Masse-Systems verursacht wird.

Die US 2012/02779792 A1 offenbart eine mikromechanische piezoresistive Sensorvorrichtung.

Obwohl auf beliebige mikromechanische Sensoranordnungen anwendbar, werden die vorliegende Erfindung und die ihr zugrundeliegende Problematik in Bezug auf mikromechanische Drucksensoranordnungen erläutert.

### Stand der Technik

MEMS-Beschleunigungssensoren werden hauptsächlich in der Automobilelektronik und der Verbraucherelektronik eingesetzt. Heutzutage beruhen die meisten MEMS-Beschleunigungssensoren auf dem Prinzip der kapazitiven Erfassung.

Ein neuer Ansatz unter Verwendung von piezoresistiven Sensorwiderstandsbalken wurde von Robert et al., "M&NEMS: New Approach for Ultra-low Cost 3D Inertial Sensor", IEEE Sensors 2009 Conference, Christchurch, October 25 - 28, 2009, Seiten 963 - 966, vorgestellt. Dieser Ansatz kombiniert einen MEMS-Bereich, der sensitiv gegenüber Inertialkräften ist, mit einem NEMS-Bereich zur Erfassung, wobei letzterer einen aufgehängten Silizium-Sensorwiderstandsbalken im Nanometerbereich aufweist.

Dieser Sensorwiderstandsbalken besteht aus einkristallinem Silizium. Die Vorteile des piezoresistiven Ansatzes gegenüber dem kapazitiven Ansatz liegen in einer vereinfachten ASIC-Auswertung, an kleinem Platzbedarf für die Sensorwiderstandsbalken, und einer linearen Auswertung.

Bekannte Sensoren nach dem piezoresistiven Ansatz umfassen nicht nur Beschleunigungssensoren, sondern auch Drehratensensoren, Drucksensoren, Magnetsensoren usw.

A. Walther et al., "3-Axis Gyroscope with Si Nanogage Piezo-Resistive Detection", MEMS 2012, Paris, Frankreich, 29. Januar - 2. Februar 2012, Seiten 480 - 483, offenbaren einen beispielhaften technologischen Ansatz für einen Beschleunigungssensor mit piezoresistiver Erfassung.

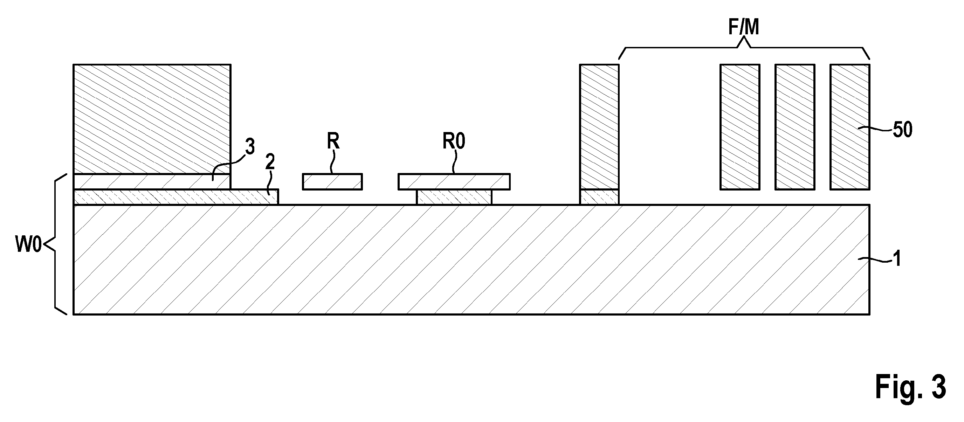

Fig. 3 ist eine schematische vertikale Querschnittsdarstellung einer mikromechanischen Sensoranordnung mit piezoresistiver Erfassung zur Illustration der der vorliegenden Erfindung zugrundeliegenden Problematik.

In Fig. 3 bezeichnet Bezugszeichen 1 ein Siliziumsubstrat mit einer darauf befindlichen Isolationsschicht 2, beispielsweise aus Siliziumoxid, und einer darauf befindlichen relativ dünnen piezoresistiven einkristallinen Siliziumschicht 3. Diese einkristalline Siliziumschicht ist beispielsweise 250 nm dick. Zur Herstellung wird vorzugsweise ein SOI-Wafer WO mit den Schichten 1, 2 und 3 herangezogen.

Die einkristalline Siliziumschicht 3 wird mittels bekannter Trenchätzverfahren und Opferschichtätzverfahren strukturiert, um darin einen piezoresistiven Sensorwiderstandsbalken R herauszustrukturieren, welcher über eine (nicht gezeigte) Federbalkenstruktur mit einem Sensorwiderstandsbereich R0 verbunden ist, der über die Oxidschicht 2 mit dem Substrat 1 verbunden ist.

Auf der Siliziumschicht 3 ist ein Feder-Masse-System F/M, welches in Fig. 3 nur teilweise dargestellt ist, aus einer Epipolysiliziumschicht 50 herausstrukturiert.

Das auf Inertialkräfte sensitive Feder-Masse-System F/M ist über eine nicht gezeigte Verbindungsstruktur, welche außerhalb der Schnittlinie von Fig. 3 verläuft, mit dem Sensorwiderstandsbalken R verbunden, sodass auf das Feder-Masse-System F/M wirkende Inertialkräfte eine Verformung des Sensorwiderstandsbalkens R verursachen, welche letztlich zur Induktion einer messbaren Spannung führen.

Die Verwendung von der epitaktisch abgeschiedenen Polysiliziumschicht 50 für das Feder-Masse-System F/M kann jedoch problematisch bezüglich Prozesstoleranzen, Miniaturisierung und Bestimmtheit von Materialparametern sein. Hauptsächlich liegt das am kristallinen Charakter des Polysiliziums, dessen Korngrenzen in der Größenordnung der Federn liegen. Aus diesem Grund bestehen die Federn nicht mehr aus unendlich vielen Körnern mit einer isotropen Verteilung der Kristallorientierung, sondern aus einer variablen Anzahl von anisotropen Körnern. Daraus ergibt sich eine erhöhte Unsicherheit bei der Definition und Auslegung der Federparameter.

Auf dem SOI-Wafer W0 werden im Prozessverlauf sukzessive Maskier- und Epi-Polysiliziumschichten abgeschieden und strukturiert. Hierbei ist die anwachsende Topografie und die Anzahl an Abscheidungen ein entscheidender Faktor für erhöhte Prozessunsicherheiten. Aufgrund von Topografie-Unterschieden ist es schwieriger, eine hochpräzise Lithografie durchzuführen. Dies führt zu einer horizontalen Geometrieunsicherheit. Die vertikale Geometrieunsicherheit resultiert darin, dass die Schichten, hauptsächlich die polykristallinen Epi-Polysiliziumschichten, relativ rau aufgewachsen werden. Um diese zu glätten und wieder auf einen definierten Wert zu bringen, müssen sie über CMP-Polierschritte zurückgeschliffen werden. Dabei wird die Qualität der CMP-Schritte hauptsächlich vom Verhältnis des CMP-Abtrags zur initialen Rauigkeit bestimmt. Die Qualität korreliert direkt mit diesem Wert. Aus wirtschaftlichen Gründen möchte man die zusätzliche, durch den CMP-Schritt entfernte Schichtdicke gering halten, da die Abscheidungskosten vergleichsweise hoch sind. Der Kompromiss führt daher nie zu einer optimalen Schichtqualität.

### Offenbarung der Erfindung

Die vorliegende Erfindung schafft eine mikromechanische Sensoranordnung nach Anspruch 1 und ein entsprechendes Herstellungsverfahren nach Anspruch 11.

Bevorzugte Weiterbildungen sind Gegenstand der jeweiligen Unteransprüche.

### Vorteile der Erfindung

Die der vorliegenden Erfindung zugrunde liegende Idee besteht darin, eine über der ersten einkristallinen Funktionsschicht angeordnete zweite Isolationsschicht und eine über der zweiten Isolationsschicht angeordnete zweite einkristalline Funktionsschicht, in der ein Feder-Masse-System ausgebildet ist, welches mechanisch mit dem piezoresistiver Sensorwiderstandsbalken gekoppelt ist, vorzusehen.

Die erfindungsgemäße mikromechanische Sensoranordnung nach Anspruch 1 und das entsprechende Herstellungsverfahren nach Anspruch 11 erlauben, dass der Elastizitätsmodul des Feder-Masse-Systems eindeutig definiert ist. Hochpräzise kristallorientierte Ätzverfahren können an dem Feder-Masse-System aus einkristallinem Silizium durchgeführt werden. Die Bruchfestigkeit des einkristallinen Materials ist wesentlich höher als diejenige des polykristallinen Materials. Durch die fehlende Topografie und die Einkristallinität lässt sich eine gewünschte Schichtdicke genauer einstellen und lassen sich die anschließenden Lithografieschritte ebenfalls präziser durchführen.

Von daher bildet die Verwendung von einkristallinem Silizium für das Feder-Masse-System den Ausgangspunkt für eine weitere Miniaturisierung der Federn bzw. des gesamten derartigen Sensorsystems.

Gemäß einer bevorzugten Ausführungsform ist das Feder-Masse-System über die zweite Isolationsschicht mit dem piezoresistiver Sensorwiderstandsbalken gekoppelt, wobei ein oder mehrere erste elektrische Durchkontaktierungen zum elektrischen Kontaktieren des piezoresistiven Sensorwiderstandsbalkens vorgesehen sind, welche durch die zweite Funktionsschicht und die zweite Isolationsschicht verlaufen. Dies ermöglich eine einfache Kontaktierung von der Oberseite her.

Gemäß einer weiteren bevorzugten Ausführungsform ist der piezoresistive Sensorwiderstandsbalken über die erste Isolationsschicht mit der Substratschicht mechanisch verbunden und die die erste Isolationsschicht zumindest teilweise unterhalb des piezoresistiven Sensorwiderstandsbalkens entfernt. So lässt sich der Sensorwiderstandsbalken beispielsweise durch Opferschichtätzen freistellen.

Gemäß einer weiteren bevorzugten Ausführungsform sind die erste Funktionsschicht und die zweite Funktionsschicht aus einkristallinem Silizium gebildet. Einkristallines Silizium ist ein durch bekannte Ätztprozesse exakt strukturierbares Material.

Gemäß einer weiteren bevorzugten Ausführungsform sind die erste Isolationsschicht und die zweite Isolationsschicht aus Siliziumoxid gebildet.

Gemäß einer weiteren bevorzugten Ausführungsform sind die ersten Durchkontaktierungen aus polykristallinem Silizium oder aus polykristallinem Polysilizium-Germanium gebildet. Dies geschieht vorzugsweise durch eine konforme Abscheidung.

Gemäß einer weiteren bevorzugten Ausführungsform ist weiterhin eine Verkappung vorgesehen, welche eine dritte Funktionsschicht aufweist, die über eine Verbindungsschicht mit der zweiten Funktionsschicht mechanisch verbunden ist. So lässt sich eine definierte Sensoratmosphäre einstellen.

Gemäß einer weiteren bevorzugten Ausführungsform sind ein oder mehrere zweite elektrische Durchkontaktierungen vorgesehen, welche durch die dritte Funktionsschicht und die Verbindungschicht verlaufen. So kann die elektrische Kontaktierung über die Sensorkappe erfolgen.

Gemäß einer weiteren bevorzugten Ausführungsform sind die Substratschicht, die über der Substratschicht angeordnete erste Isolationsschicht und die über der ersten Isolationsschicht angeordnete erste einkristalline Funktionsschicht als SOI-Wafer ausgebildet. Dies vereinfacht die Herstellung.

Gemäß einer weiteren bevorzugten Ausführungsform ist die erste Funktionsschicht mit der zweiten Isolationsschicht über eine Direktbondverbindung verbunden. Dies führt zu einer weiteren Vereinfachung der Herstellung.

### Kurze Beschreibung der Zeichnungen

Die vorliegende Erfindung wird nachfolgend anhand der in den schematischen Figuren der Zeichnungen angegebenen Ausführungsbeispiele näher erläutert.

Es zeigen:
- Fig. 1: eine schematische vertikale Querschnittsdarstellung einer mikromechanischen Sensoranordnung gemäß einer ersten Ausführungsform der vorliegenden Erfindung;
- Fig. 2: eine schematische vertikale Querschnittsdarstellung einer mikromechanischen Sensoranordnung gemäß einer zweiten Ausführungsform der vorliegenden Erfindung; und
- Fig. 3: eine schematische vertikale Querschnittsdarstellung einer mikromechanischen Sensoranordnung mit piezoresistiver Erfassung zur Illustration der der vorliegenden Erfindung zugrundeliegenden Problematik.

### Ausführungsformen der Erfindung

In den Figuren bezeichnen gleiche Bezugszeichen gleiche bzw. funktionsgleiche Elemente.

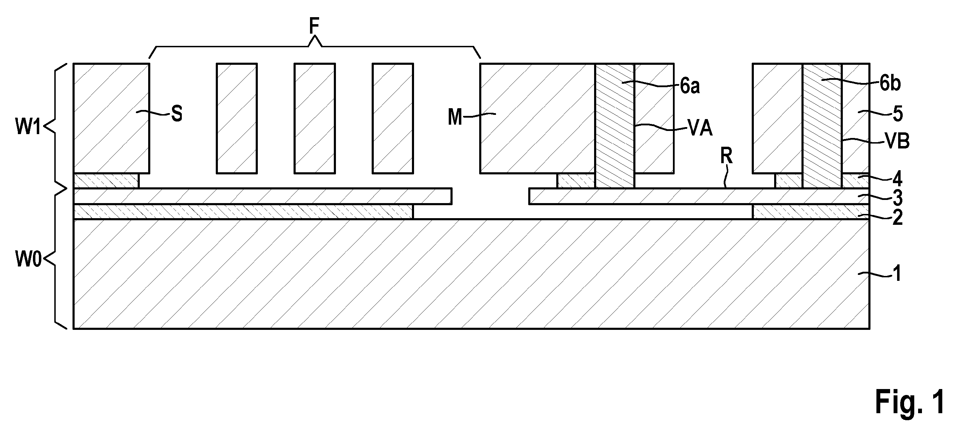

Fig. 1 ist eine schematische vertikale Querschnittsdarstellung einer mikromechanischen Sensoranordnung gemäß einer ersten Ausführungsform der vorliegenden Erfindung.

In Fig. 1 bezeichnet Bezugszeichen 1 ein monokristallines Siliziumsubstrat, auf dem eine erste Isolationsschicht 2, vorzugsweise eine Siliziumoxidschicht, vorgesehen ist. Die Anforderung an das Siliziumsubstrat 1 besteht darin, Umwelteinflüsse, wie z.B. Druck, von der Sensoranordnung fernzuhalten und eine elektrische Abschirmung der Sensoranordnung zu ermöglichen. Die erste Isolationsschicht 2 aus Siliziumoxid dient als Opferschicht, um darüberliegende Komponenten, welche nachstehend erläutert werden, freizustellen, also beweglich zu machen. Auf der ersten Isolationsschicht 2 aus Siliziumoxid ist eine dünne einkristalline piezoresistive Siliziumschicht 3 vorgesehen, deren Dicke typischerweise 250 um beträgt. Ausgangspunkt für die technologische Herstellung ist wie beim bekannten System gemäß Fig. 3 zweckmäßigerweise ein SOI-Wafer W0.

Über der einkristallinen piezoresistiven Siliziumschicht 3 ist eine zweite Isolationsschicht 4, hier ebenfalls aus Siliziumoxid, vorgesehen, welche erstens als Maskierungsschutzschicht über einem aus der einkristallinen piezoresistiven Siliziumschicht 3 herausstrukturierten Sensorwiderstandsbalken R dient, zweitens als Opferschicht für das Feder-Masse-System S, F, M dient und drittens die Funktion einer Bondschicht für ein Silizium-Direktbonden dient, welches nachstehend erläutert wird.

Über der zweiten Isolationsschicht 4 aus Siliziumoxid ist eine weitere einkristalline Siliziumschicht 5 vorgesehen, aus der das Feder-Masse-System S, F, M herausstrukturiert ist.

Das Feder-Masse-System S, F, M weist bei dem Beispiel gemäß Fig. 1 einen Sockel S auf, der über die zweite Isolationsschicht 4 mit der ersten piezoresistiven einkristallinen Siliziumschicht 3 verbunden ist. Weiterhin ist eine Masse M vorgesehen, welche ebenfalls über die zweite Isolationsschicht 4 mit einem freischwebenden Sensorwiderstandsbalken R verbunden ist. Weiterhin vorgesehen ist eine Federeinrichtung F, welche den Sockel S mit der Masse M verbindet.

Um eine elektrische Kontaktierung zwischen der zweiten einkristallinen Siliziumschicht 5 und dem piezoresistiven Sensorwiderstandsbalken R zu schaffen, werden zunächst Durchgangslöcher VA, VB gebildet, welche anschließend durch konforme Abscheidung einer elektrisch leitfähigen Schicht, beispielsweise aus Polysilizium oder Polysilizium-Germanium, gefüllt werden. Die elektrischen Durchkontaktierungen sind mit Bezugszeichen 6a, 6b bezeichnet.

Im Betrieb führen Inertialkräfte zu einer Auslenkung der federnd aufgehängten Masse M, was in Verformungen des Sensorwiderstandsbalkens R resultiert, wobei die damit im Zusammenhang stehenden Spannungen über die elektrischen Kontaktierungen 6a, 6b abgegriffen werden können.

Zur Herstellung startet die erste Ausführungsform, wie bereits erwähnt, mit dem SOI-Wafer W0. Anschließend wird die erste monokristalline Siliziumschicht 3 strukturiert. In einem weiteren Prozessschritt wird ein Quasi-SOI-Wafer W1 herangezogen, welcher die zweite monokristalline Siliziumschicht 5 sowie die darauf befindliche zweite Isolationsschicht 4 aus Siliziumoxid aufweist. Der zweite Wafer W1 wird über die zweite Isolationsschicht 4 auf die erste monokristalline Siliziumschicht 3 des ersten Wafers W0 mittels des Silizium-Direktbondverfahrens gebondet. Anschließend kann die zweite monokristalline Siliziumschicht 5 auf eine gewünschte Dicke topografiefrei zurückgeschliffen werden. Dabei kann das Verhältnis des CMP-Abtrags zur initialen Rauigkeit günstiger gewählt werden, da ein dickeres Ausgangssubstrat vergleichsweise günstiger ist als eine dickere abgeschiedene Schicht.

Nach dem Direktbondschritt lässt sich das Feder-Masse-System S, F, M mittels eines Trenchätzprozesses strukturieren, und in einem letzten Schritt lassen sich die erste und zweite Isolationsschicht 2, 4 durch einen Opferätzschritt an den gewünschten Stellen entfernen, um das System freizustellen.

Eine alternative Möglichkeit, die zweite monokristalline Siliziumschicht 5 auf dem ersten Wafer W0 zu bilden, besteht darin, einen passenden monokristallinen Siliziumwafer mit einer initialen Schichtdicke von 1 bis 100 µm zu verwenden. Dabei lässt sich ein Handlingwafer (nicht gezeigt) verwenden, welcher nach dem Direktbondschritt, aber vor dem Tempern/Anneal der Direktbondverbindung entfernt wird. Für eine horizontale Geometrieunsicherheit sind gerade die stark reduzierte Topografie und die spiegelnde Oberfläche vorteilhaft und führt zu besseren Ergebnissen als eine mit einem CMP-Schritt zurückgeschliffene Epi-Polysiliziumschicht.

Besonders vorteilhaft ist das Vorhandensein der zweiten Isolationsschicht 4, da sie die Möglichkeit bietet, eine Verdrahtungsebene zu enthalten. Darüber hinaus können auch freigestellte weitere Kapazitäten darin ausgebildet werden (nicht gezeigt), welche für eine zusätzliche redundante kapazitive Messung verwendet werden können, oder, falls notwendig, zum elektrostatischen Antrieb oder Bewegungskorrektur, Quadraturkompensation usw.

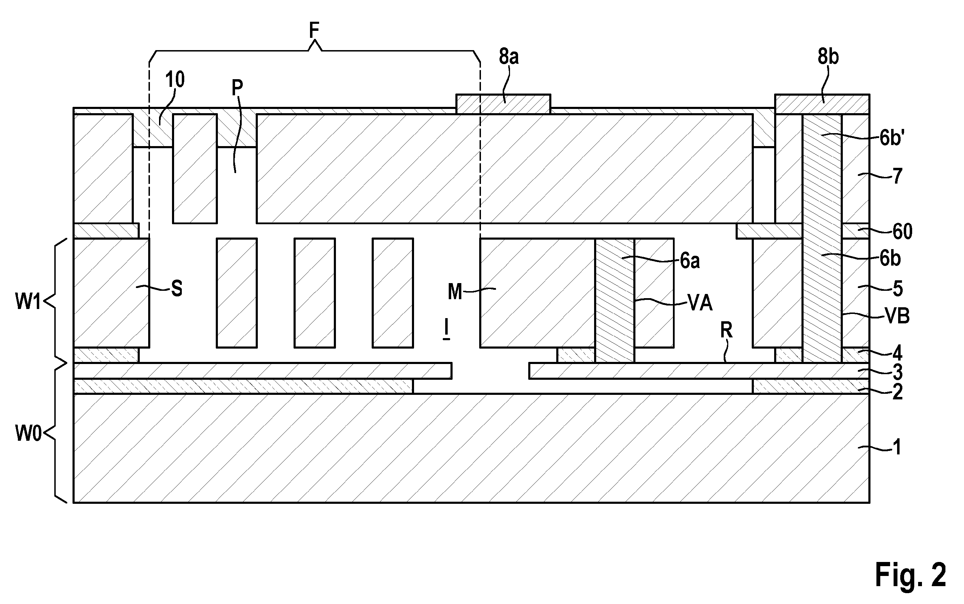

Fig. 2 ist eine schematische vertikale Querschnittsdarstellung einer mikromechanischen Sensoranordnung gemäß einer zweiten Ausführungsform der vorliegenden Erfindung.

Bei der zweiten Ausführungsform ist die erste Ausführungsform durch eine Verkappung ergänzt. Diese Verkappung besteht aus einer weiteren Funktionsschicht 7, beispielsweise ebenfalls aus monokristallinem Silizium, und einer Verbindungsschicht 60, über die die Funktionsschicht 7 mit der zweiten monokristallinen Siliziumschicht 5 verbunden ist. In der Funktionsschicht 7 sind Perforationslöcher P vorgesehen, welche durch eine Verschlussschicht 10, beispielsweise aus Siliziumnitrid, verschlossen sind. Diese Perforationslöcher dienen beispielsweise zum Evakuieren des Innenraums I der Sensoranordnung.

Elektrische Kontakte 8a, 8b sind an der Oberseite der Funktionsschicht 7 vorgesehen. Die erste elektrische Durchkontaktierung 6a des Sensorwiderstandsbalkens R ist über eine (nicht dargestellte) Verbindung mit dem ersten elektrischen Kontakt 8a verbunden. Die zweite elektrische Durchkontaktierung 6b ist über eine weitere Durchkontaktierung 6b' in der Funktionsschicht 7 mit dem Kontakt 8b verbunden. So lassen sich die elektrischen Signale des Sensorwiderstandsbalkens R an der Oberseite des Gehäuses abgreifen.

Obwohl die vorliegende Erfindung anhand bevorzugter Ausführungsbeispiele vorstehend vollständig beschrieben wurde, ist sie darauf nicht beschränkt, sondern auf vielfältige Art und Weise modifizierbar.

Insbesondere sind die erläuterten Materialien und Topologien nur beispielhaft.

## Patentansprüche

1. Mikromechanische Sensoranordnung mit:
einer Substratschicht (1);
einer über der Substratschicht (1) angeordneten ersten Isolationsschicht (2);
einer über der ersten Isolationsschicht (2) angeordneten ersten einkristallinen Funktionsschicht (3), in der ein piezoresistiver Sensorwiderstandsbalken (R) ausgebildet ist;
einer über der ersten einkristallinen Funktionsschicht (3) angeordneten zweiten Isolationsschicht (4); und
einer über der zweiten Isolationsschicht (4) angeordneten zweiten einkristallinen Funktionsschicht (5), in der ein Feder-Masse-System (S, F, M) ausgebildet ist, welches mechanisch mit dem piezoresistiver Sensorwiderstandsbalken (R) gekoppelt ist.

2. Mikromechanische Sensoranordnung nach Anspruch 1, wobei das Feder-Masse-System (S, F, M) über die zweite Isolationsschicht (4) mit dem piezoresistiver Sensorwiderstandsbalken (R) gekoppelt ist und wobei ein oder mehrere erste elektrische Durchkontaktierungen (6a, 6b) zum elektrischen Kontaktieren des piezoresistiven Sensorwiderstandsbalkens (R) vorgesehen sind, welche durch die zweite Funktionsschicht (5) und die zweite Isolationsschicht (4) verlaufen.

3. Mikromechanische Sensoranordnung nach Anspruch 1 oder 2, wobei der piezoresistive Sensorwiderstandsbalken (R) über die erste Isolationsschicht (2) mit der Substratschicht (1) mechanisch verbunden ist und die die erste Isolationsschicht (2) zumindest teilweise unterhalb des piezoresistiven Sensorwiderstandsbalkens (R) entfernt ist.

4. Mikromechanische Sensoranordnung nach einem der vorhergehenden Ansprüche, wobei die erste Funktionsschicht (3) und die zweite Funktionsschicht (5) aus einkristallinem Silizium gebildet sind.

5. Mikromechanische Sensoranordnung nach einem der vorhergehenden Ansprüche, wobei die erste Isolationsschicht (2) und die zweite Isolationsschicht (4) aus Siliziumoxid gebildet sind.

6. Mikromechanische Sensoranordnung nach Anspruch 2, wobei die ersten Durchkontaktierungen (6a, 6b) aus polykristallinem Silizium oder aus polykristallinem Polysilizium-Germanium gebildet sind.

7. Mikromechanische Sensoranordnung nach einem der vorhergehenden Ansprüche, wobei weiterhin eine Verkappung vorgesehen ist, welche eine dritte Funktionsschicht (7) aufweist, die über eine Verbindungsschicht (60) mit der zweiten Funktionsschicht (5) mechanisch verbunden ist.

8. Mikromechanische Sensoranordnung nach Anspruch 7, wobei ein oder mehrere zweite elektrische Durchkontaktierungen (6b') vorgesehen sind, welche durch die dritte Funktionsschicht (7) und die Verbindungschicht (6) verlaufen.

9. Mikromechanische Sensoranordnung nach einem der vorhergehenden Ansprüche, wobei die Substratschicht (1), die über der Substratschicht (1) angeordnete erste Isolationsschicht (2) und die über der ersten Isolationsschicht (2) angeordnete erste einkristalline Funktionsschicht (3) als SOI-Wafer (W0) ausgebildet sind.

10. Mikromechanische Sensoranordnung nach einem der vorhergehenden Ansprüche, wobei erste Funktionsschicht (3) mit der zweiten Isolationsschicht (4) über eine Direktbondverbindung verbunden ist.

11. Herstellungsverfahren für eine mikromechanische Sensoranordnung mit den Schritten:
Bereitstellen einer Substratschicht (1);
Bilden einer über der Substratschicht (1) angeordneten ersten Isolationsschicht (2);
Bilden einer über der ersten Isolationsschicht (2) angeordneten ersten einkristallinen Funktionsschicht (3), in der ein piezoresistiver Sensorwiderstandsbalken (R) ausgebildet wird;
Bilden einer über der ersten einkristallinen Funktionsschicht (3) angeordneten zweiten Isolationsschicht (4); und
Bilden einer über der zweiten Isolationsschicht (4) angeordneten zweiten einkristallinen Funktionsschicht (5), in der ein Feder-Masse-System (S, F, M) ausgebildet wird, welches mechanisch mit dem piezoresistiver Sensorwiderstandsbalken (R) gekoppelt ist.

12. Herstellungsverfahren nach Anspruch 11, wobei die Substratschicht (1), die über der Substratschicht (1) angeordnete erste Isolationsschicht (2) und die über der ersten Isolationsschicht (2) angeordnete erste einkristalline Funktionsschicht (3) als SOI-Wafer (W0) ausgebildet werden, wobei die zweite einkristalline Funktionsschicht (5) und die zweite Isolationsschicht (4) als weiterer Wafer (W1) ausgebildet werden und wobei die erste Funktionsschicht (3) mit der zweiten Isolationsschicht (4) über eine Direktbondverbindung verbunden wird.

13. Herstellungsverfahren nach Anspruch 12, wobei die zweite einkristalline Funktionsschicht (5) und die zweite Isolationsschicht (4) über den Devicelayer eines weitereren SOI Wafer (W1) ausgebildet werden und wobei der Handlingwafer des SOI Wafers nach dem Direktbonden entfernt wird.

14. Herstellungsverfahren nach einem der Ansprüche 11 bis 13, wobei das Feder-Masse-System (S, F, M) über die zweite Isolationsschicht (4) mit dem piezoresistiver Sensorwiderstandsbalken (R) gekoppelt wird und wobei ein oder mehrere erste elektrische Durchkontaktierungen (6a, 6b) zum elektrischen Kontaktieren des piezoresistiven Sensorwiderstandsbalkens (R) vorgesehen werden, welche durch die zweite Funktionsschicht (5) und die zweite Isolationsschicht (4) verlaufen

15. Herstellungsverfahren nach einem der Ansprüche 11 bis 14, wobei der piezoresistive Sensorwiderstandsbalken (R) über die erste Isolationsschicht (2) mit der Substratschicht (1) mechanisch verbunden wird und die die erste Isolationsschicht (2) zumindest teilweise unterhalb des piezoresistiven Sensorwiderstandsbalkens (R) entfernt wird.

## Claims

1. Micromechanical sensor arrangement comprising:
a substrate layer (1);
a first insulation layer (2) arranged above the substrate layer (1);
a first monocrystalline functional layer (3) arranged above the first insulation layer (2), a piezoresistive sensor resistance bar (R) being formed in said first monocrystalline functional layer;
a second insulation layer (4) arranged above the first monocrystalline functional layer (3); and
a second monocrystalline functional layer (5) arranged above the second insulation layer (4), a spring-mass system (S, F, M) being formed in said second monocrystalline functional layer, said spring-mass system being mechanically coupled to the piezoresistive sensor resistance bar (R).

2. Micromechanical sensor arrangement according to Claim 1, wherein the spring-mass system (S, F, M) is coupled to the piezoresistive sensor resistance bar (R) via the second insulation layer (4), and wherein one or a plurality of first electrical plated-through holes (6a, 6b) for electrically contacting the piezoresistive sensor resistance bar (R) are provided which run through the second functional layer (5) and the second insulation layer (4).

3. Micromechanical sensor arrangement according to Claim 1 or 2, wherein the piezoresistive sensor resistance bar (R) is mechanically connected to the substrate layer (1) via the first insulation layer (2), and the first insulation layer (2) is removed at least partly below the piezoresistive sensor resistance bar (R).

4. Micromechanical sensor arrangement according to any of the preceding claims, wherein the first functional layer (3) and the second functional layer (5) are formed from monocrystalline silicon.

5. Micromechanical sensor arrangement according to any of the preceding claims, wherein the first insulation layer (2) and the second insulation layer (4) are formed from silicon oxide.

6. Micromechanical sensor arrangement according to Claim 2, wherein the first plated-through holes (6a, 6b) are formed from polycrystalline silicon or polycrystalline polysilicon-germanium.

7. Micromechanical sensor arrangement according to any of the preceding claims, wherein a capping is furthermore provided, which comprises a third functional layer (7) mechanically connected to the second functional layer (5) via a connection layer (60).

8. Micromechanical sensor arrangement according to Claim 7, wherein one or a plurality of second electrical plated-through holes (6b') are provided which run through the third functional layer (7) and the connection layer (6).

9. Micromechanical sensor arrangement according to any of the preceding claims, wherein the substrate layer (1), the first insulation layer (2) arranged above the substrate layer (1), and the first monocrystalline functional layer (3) arranged above the first insulation layer (2) are embodied as an SOI wafer (W0).

10. Micromechanical sensor arrangement according to any of the preceding claims, wherein the first functional layer (3) is connected to the second insulation layer (4) via a direct bonding connection.

11. Production method for a micromechanical sensor arrangement comprising the following steps:
providing a substrate layer (1);
forming a first insulation layer (2) arranged above the substrate layer (1);
forming a first monocrystalline functional layer (3) arranged above the first insulation layer (2), a piezoresistive sensor resistance bar (R) being formed in said first monocrystalline functional layer;
forming a second insulation layer (4) arranged above the first monocrystalline functional layer (3); and
forming a second monocrystalline functional layer (5) arranged above the second insulation layer (4), a spring-mass system (S, F, M) being formed in said second monocrystalline functional layer, said spring-mass system being mechanically coupled to the piezoresistive sensor resistance bar (R).

12. Production method according to Claim 11, wherein the substrate layer (1), the first insulation layer (2) arranged above the substrate layer (1), and the first monocrystalline functional layer (3) arranged above the first insulation layer (2) are embodied as an SOI wafer (W0), wherein the second monocrystalline functional layer (5) and the second insulation layer (4) are embodied as a further wafer (W1), and wherein the first functional layer (3) is connected to the second insulation layer (4) via a direct bonding connection.

13. Production method according to Claim 12, wherein the second monocrystalline functional layer (5) and the second insulation layer (4) are formed above the device layer of a further SOI wafer (W1), and wherein the handling wafer of the SOI wafer is removed after the direct bonding.

14. Production method according to any of Claims 11 to 13, wherein the spring-mass system (S, F, M) is coupled to the piezoresistive sensor resistance bar (R) via the second insulation layer (4), and wherein one or a plurality of first electrical plated-through holes (6a, 6b) for electrically contacting the piezoresistive sensor resistance bar (R) are provided which run through the second functional layer (5) and the second insulation layer (4).

15. Production method according to any of Claims 11 to 14, wherein the piezoresistive sensor resistance bar (R) is mechanically connected to the substrate layer (1) via the first insulation layer (2), and the first insulation layer (2) is removed at least partly below the piezoresistive sensor resistance bar (R).

## Revendications

1. Agencement de capteur micro-mécanique comportant:
une couche de substrat (1) ;
une première couche d'isolation (2) disposée sur la couche de substrat (1) ;
une première couche fonctionnelle (3) monocristalline disposée sur la première couche d'isolation (2), dans laquelle une barre de résistance de capteur (R) piézorésistive est réalisée ;
une deuxième couche d'isolation (4) disposée sur la première couche fonctionnelle monocristalline (3) ;et
une deuxième couche fonctionnelle (5) monocristalline disposée sur la deuxième couche d'isolation (4), dans laquelle un système ressort-masse (S,F,M) est réalisé, qui est couplé mécaniquement avec la barre de résistance de capteur piézorésistive (R).

2. Agencement de capteur micro-mécanique selon la revendication 1, dans lequel le système ressort-masse (S,F,M) est couplé par l'intermédiaire de la deuxième couche d'isolation (4) avec la barre de résistance de capteur piézorésistive (R) et dans lequel un ou plusieurs premiers contacts de passage électriques (6a,6b) sont prévus afin de contacter électriquement la barre de résistance de capteur piézorésistive (R), qui s'étendent à travers la deuxième couche fonctionnelle (5) et la deuxième couche d'isolation (4).

3. Agencement de capteur micro-mécanique selon la revendication 1 ou 2, dans lequel la barre de résistance de capteur piézorésistive (R) est reliée mécaniquement par l'intermédiaire de la première couche d'isolation (2) avec la couche de substrat (1) et la première couche d'isolation (2) est éliminée au moins partiellement au-dessous de la barre de résistance de capteur piézorésistive (R).

4. Agencement de capteur micro-mécanique selon une des revendications précédentes, dans lequel la première couche fonctionnelle (3) et la deuxième couche fonctionnelle (5) sont formées en silicium monocristallin.

5. Agencement de capteur micro-mécanique selon une des revendications précédentes, dans lequel la première couche d'isolation (2) et la deuxième couche d'isolation (4) sont formées en oxyde de silicium.

6. Agencement de capteur micro-mécanique selon la revendication 2, dans lequel les premiers contacts de passage (6a,6b) sont formés en silicium polycristallin ou en polysilicium polycristallin-germanium.

7. Agencement de capteur micro-mécanique selon une des revendications précédentes, dans lequel une encapsulation est en outre prévue, qui présente une troisième couche fonctionnelle (7), qui est reliée mécaniquement par l'intermédiaire d'une couche de liaison (60) avec la deuxième couche fonctionnelle (5).

8. Agencement de capteur micro-mécanique selon la revendication 7, dans lequel un ou plusieurs deuxièmes contacts de passage électriques (6b') sont prévus, lesquels s'étendent à travers la troisième couche fonctionnelle (7) et la couche de liaison (6).

9. Agencement de capteur micro-mécanique selon une des revendications précédentes, dans lequel la couche de substrat (1), la première couche d'isolation (2) disposée sur la couche de substrat (1) et la première couche fonctionnelle (3) monocristalline disposée sur la première couche d'isolation (2) sont réalisées comme des plaquettes SOI (W0).

10. Agencement de capteur micro-mécanique selon une des revendications précédentes, dans lequel une première couche fonctionnelle (3) est reliée avec la deuxième couche d'isolation (4) par une liaison par bonding direct.

11. Procédé de fabrication pour agencement de capteur micro-mécanique comportant les étapes consistant à :
fournir une couche de substrat (1) ;
former une première couche d'isolation (2) disposée sur la couche de substrat (1) ;
former une première couche fonctionnelle (3) monocristalline disposée sur la première couche d'isolation (2), dans laquelle une barre de résistance de capteur piézorésistive (R) est réalisée ;
former une deuxième couche d'isolation (4) disposée sur la première couche fonctionnelle (3) monocristalline ; et
former une deuxième couche fonctionnelle microcristalline (5) disposée sur la deuxième couche d'isolation (4), dans laquelle un système ressort-masse (S,F,M) est réalisé, qui est couplé mécaniquement avec la barre de résistance de capteur piézorésistive (R).

12. Procédé de fabrication selon la revendication 11, dans lequel la couche de substrat (1), la première couche d'isolation (2) disposée sur la couche de substrat (1) et la première couche fonctionnelle (3) monocristalline disposée sur la première couche d'isolation (2) sont réalisées comme des plaquettes SOI (W0), dans lequel la deuxième couche fonctionnelle monocristalline (5) et la deuxième couche d'isolation (4) sont conçues comme des plaquettes supplémentaires (W1) et dans lequel la première couche fonctionnelle (3) est reliée avec la deuxième couche d'isolation (4) par une liaison par bonding direct.

13. Dispositif de fabrication selon la revendication 12, dans lequel la deuxième couche fonctionnelle monocristalline (5) et la deuxième couche d'isolation (4) sont réalisés par l'intermédiaire de la couche de dispositif d'une plaquette SOI supplémentaire (W1) et dans lequel la couche de manipulation de la plaquette SOI est éliminée après le bonding direct.

14. Procédé de fabrication selon une des revendications 11 à 13, dans lequel le système ressort-masse (S,F,M) est couplé par l'intermédiaire de la deuxième couche d'isolation (4) avec la barre de résistance de capteur piézorésistive (R) et dans lequel un ou plusieurs premiers contacts de passage électriques (6a,6b) sont prévus pour le contact électrique de la barre de résistance de capteur piézorésistive (R), lesquels s'étendent à travers la deuxième couche fonctionnelle (5) et la deuxième couche d'isolation (4).

15. Procédé de fabrication selon une des revendications 11 à 14, dans lequel la barre de résistance de capteur piézorésistive (R) est reliée mécaniquement par la première couche d'isolation (2) avec la couche de substrat (1) et la première couche d'isolation (2) est éliminée au moins partiellement au-dessous de la barre de résistance de capteur piézorésistive (R).
